# EUROPEAN PATENT APPLICATION

(11) **EP 3 425 726 A1**
(43) Date of publication of application: **09.01.2019**
(21) Application number: 18177984.4
(22) Date of filing: 15.06.2018
(51) Int. Cl.: H01Q 1/22, G02F 1/1333, H01Q 3/44

(54) **CONTROL PANEL AND RADIATION DEVICE**

(30) Priority: 06.07.2017 US 201762528999 P; 09.01.2018 CN 201810019555
(71) Applicant: InnoLux Corporation, Jhu-Nan, Miao-Li County 350 (TW)
(72) Inventor: LIN, Yi-Hung, 350 Miao-Li County (TW); TING, Chin-Lung, 350 Miao-Li County (TW); HO, Chia-Chi, 350 Miao-Li County (TW); LI, I-Yin, 350 Miao-Li County (TW)
(74) Representative: 2K Patentanwälte Blasberg Kewitz & Reichel

(57) **Abstract**

A control panel of a radiation device includes a transistor substrate. A first transistor, a second transistor, a first electrode pad, a second electrode pad, a first conductive line, and a second conductive line)are disposed on the transistor substrate. The first electrode pad is disposed adjacent to the first transistor, the second electrode pad is disposed adjacent to the second transistor, the first transistor is electrically connected to the first electrode pad through the first conductive line, and the second transistor is electrically connected to the second electrode pad through the second conductive line. The distance between the first transistor and the first electrode pad is shorter than the distance between the second transistor and the second electrode pad. The ratio of the total area of the first conductive line and the total area of the second conductive line is between 0.8 and 1.2.

## Description

### CROSS REFERENCE TO RELATED APPLICATIONS

This application claims the benefit of U.S. Provisional Application No. 62/528,999 filed July 6, 2017, the entirety of which is incorporated by reference herein.

This Application claims priority of China Patent Application No. 201810019555.9, filed on January 9, 2018, the entirety of which is incorporated by reference herein.

### BACKGROUND OF THE INVENTION

### Field of the Invention

The present disclosure relates to an electronic device, and in particular to a control panel of a radiation device that includes liquid crystal.

### Description of the Related Art

Modulation units used in radiation devices are not uniformly distributed, and the thin film transistors (TFTs) used to control the respective modulation units are arranged regularly in a matrix. Therefore, the distance between each respective thin film transistor and the modulation unit connected to it are different. Coupling capacitors formed by conductive lines of different lengths affect the voltage output to the modulation unit, resulting in a problem wherein the modulation unit cannot be operated ideally.

Therefore, at present, there is a need to solve the problem of the coupling capacitors generated by the conductive lines in the control panel of a radiation device not being consistent.

### BRIEF SUMMARY OF THE INVENTION

A detailed description is given in the following embodiments with reference to the accompanying drawings.

In view of the problems outlined above, the present disclosure provides a control panel of a radiation device that includes a transistor substrate, a first transistor, a second transistor, a first electrode pad, a second electrode pad, a first conductive line, and a second conductive line. The first transistor and the second transistor are disposed on the transistor substrate. The first electrode pad and the second electrode pad are disposed on the transistor substrate. The first electrode pad is disposed adjacent to the first transistor, and the second electrode pad is disposed adjacent to the second transistor. The first conductive line and the second conductive line are disposed on the transistor substrate. The first transistor is electrically connected to the first electrode pad through the first conductive line, and the second transistor is electrically connected to the second electrode pad through the second conductive line. A distance between the first transistor and the first electrode pad is shorter than a distance between the second transistor and the second electrode pad, and a ratio of a total area of the first conductive line and a total area of the second conductive line is between 0.8 and 1.2.

In summary, the control panel and the radiation device comprising the control panel of the present disclosure make various designs on the conducting wires, thereby bringing the coupling capacitor generated by the conductive lines close and making the operation of the radiating device more uniform and stable.

### BRIEF DESCRIPTION OF THE DRAWINGS

The present invention can be more fully understood by reading the subsequent detailed description and examples with references made to the accompanying drawings, wherein:
Fig. 1 is a schematic top view of a control panel of the radiation device of the present disclosure;
Fig. 2 is a sectional view taken along line A-A' of the control panel of Fig 1;
Figs. 3A and 3B are schematic top views of two sets of transistors and electrode pads in Embodiment 1 of the present disclosure;
Figs. 4A and 4B show equivalent circuit diagrams of portions of two sets of transistors and electrode pads in Embodiment 1 of the present disclosure;
Figs. 5A and 5B show a schematic top view of two sets of transistors and electrode pads in Embodiment 2 of the present disclosure;
Figs. 6A and 6B show a schematic top view of two sets of transistors and electrode pads in Embodiment 3 of the present disclosure;
Figs. 7A and 7B show a schematic top view of two sets of transistors and electrode pads in Embodiment 4 of the present disclosure; and
Figs. 8A and 8B show a schematic top view of two sets of transistors and electrode pads in Embodiment 5 of the present disclosure.

### DETAILED DESCRIPTION OF THE INVENTION

The following description provides many different embodiments, or examples, for implementing different features of the disclosure. Elements and arrangements described in the specific examples below are merely used for the purpose of concisely describing the present disclosure and are merely examples, which are not intended to limit the present disclosure. For example, the description of a structure in which a first feature is on or above a second feature includes that the first feature and the second feature are in direct contact with each other or there is another feature disposed between the first feature and the second feature such that the first feature and the second feature are not in direct contact.

The terms "first" and "second" of this specification are used only for the purpose of clear explanation and are not intended to limit the scope of the patent. In addition, terms such as "the first feature" and "the second feature" are not limited to the same or different features.

Spatially related terms, such as upper or lower, are used herein merely to describe briefly the relationship of one element or feature to another element or feature in the drawings. In addition to the directions described in the drawings, there are devices that are used or operated in different directions.

The shapes, dimensions, and thicknesses in the drawings may not be scaled or be simplified for clarity of illustration, and are provided for illustrative purposes only.

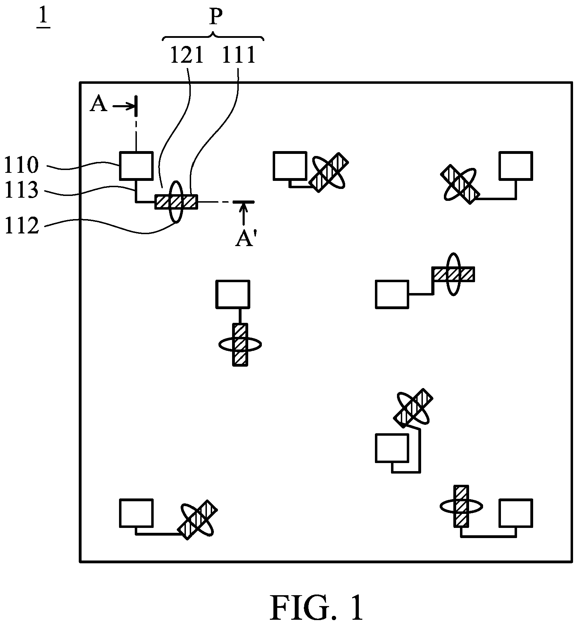

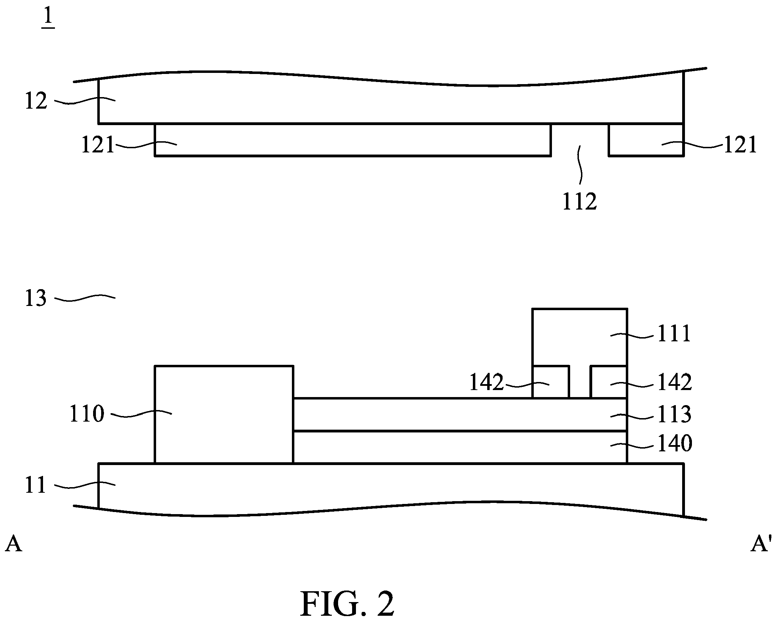

Fig. 1 is a schematic top view of a control panel of the radiation device of the present disclosure. Fig. 2 is a sectional view taken along line A-A' of the control panel of Fig 1. As shown in Fig. 1, the control panel 1 in the radiation device of the present disclosure includes a plurality of transistors 110 and a plurality of modulation units P, and the plurality of transistors 110 are arranged in a matrix (the schematic diagram shows only a part of the transistors 110). The radiation device of the present disclosure may be an antenna device operable in a high-frequency range, for example, a liquid-crystal antenna, but it is not limited thereto. In an embodiment, the high-frequency range is, for example, greater than or equal to 1 GHz and less than or equal to 80 GHz. In another embodiment, the high-frequency range is, for example, greater than or equal to 1 GHz, and less than or equal to 50 GHz. The transistor in the present disclosure may be, for example, a thin film transistor, but it is not limited thereto. Other suitable transistors may also be used in the present disclosure. The plurality of modulation units P (the schematic diagram shows only a part of the modulation units P) may be unevenly disposed on the control panel 1. The modulation unit P includes an electrode pad 111 and a counter electrode 121. The electrode pad 111 of the modulation unit P may be electrically connected to the adjacent transistor 110 through a conductive line 113. In this way, each of the modulation units P can be controlled independently by the transistor 110 to transmit or receive wireless signals.

As shown in Fig. 2, the control panel 1 in the radiation device of the present disclosure is formed of a transistor substrate 11, a counter substrate 12 and a dielectric layer 13. The counter substrate 12 is disposed opposite to the transistor substrate 11. The dielectric layer 13 is disposed between the transistor substrate 11 and the counter substrate 12. In this embodiment, the dielectric layer 13 may include a material with high birefringence, such as liquid crystal, but it is not limited thereto. The modulation unit P in the control panel 1 controls the dielectric layer 13 to transmit or receive the high-frequency radiation signal. On the side of the transistor substrate 11, the transistor 110, the conductive line 113, and the electrode pad 111 can be formed. In this embodiment, the conductive line 113 may be formed on the first insulating layer 140. The conductive line 113 may be formed of a conductive material, which may for example comprise a metal or a transparent conductive material, but it is not limited thereto. One end of the conductive line 113 is electrically connected to the transistor 110, and the other end of the conductive line 113 is electrically connected to the electrode pad 111. Specifically, the second insulating layer 142 may be disposed on the conductive line 113, and the electrode pad 111 may be disposed on the second insulating layer 142. The second insulating layer 142 may have a through hole, and the electrode pad 111 may be electrically connected to the conductive line 113 through the through hole. On the side of the counter substrate 12, the counter electrode 121 may be disposed on the surface of the counter substrate 12 facing the dielectric layer 13. The counter electrode 121 may have an opening 112 corresponding to the electrode pad 111. In an embodiment, the opening 112 partially overlaps with the electrode pad 111 in the normal direction of the transistor substrate 11, and the electrode pad 111 partially overlaps with the counter electrode 121 in the normal direction of the transistor substrate 11. A portion of the counter electrode 121 and the electrode pad 111 form a modulation unit P.

In the above structure, the electrode pad 111 may be made of a highly conductive metal (e.g. gold, silver, copper, etc.), or an alloy thereof, but it is not limited thereto. The electrode pad 111 may also be a structure in which different metals are stacked, for example, it may be a structure in which copper and molybdenum are stacked, but it is not limited thereto.

The basic configuration of the control panel 1 of the radiation device of the present disclosure has been described above. However, as shown in Fig. 1, since the distance between the transistor 110 and the electrode pad 111 is different, the conductive lines 113 electrically connecting the transistor 110 and the electrode pad 111 have different lengths. The different lengths of the conductive lines 113 form different coupling capacitors, so that the voltage supplied by the transistor 110 to the electrode pad 111 will be different. The operation of the radiation device cannot be uniformly stabilized.

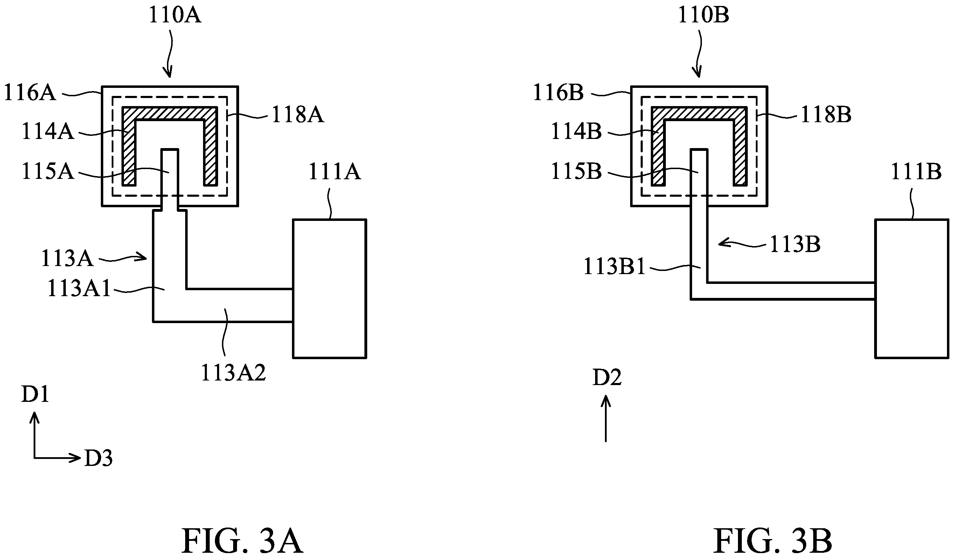

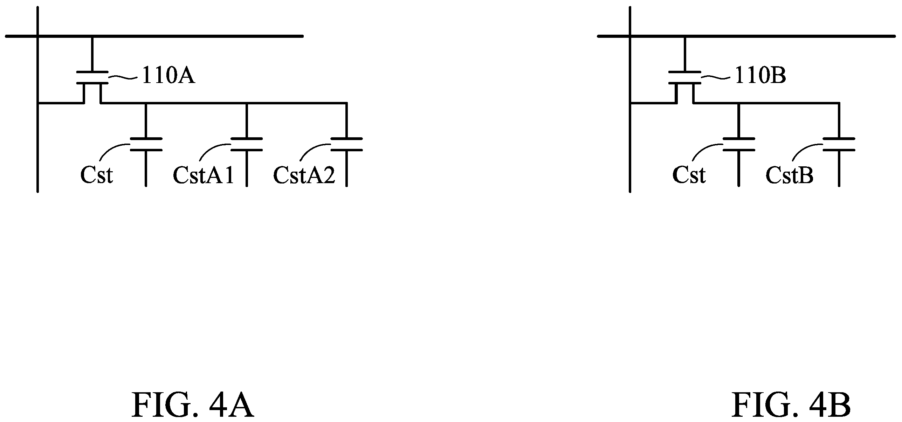

Figs. 3A and 3B are schematic top views of two sets of transistors and electrode pads in Embodiment 1 of the present disclosure. Figs. 4A and 4B show equivalent circuit diagrams of portions of two sets of transistors and electrode pads in Embodiment 1 of the present disclosure. In Figs. 3A and 3B, a first transistor 110A and a second transistor 110B are two of the plurality of transistors 110. A first electrode pad 111A and a second electrode pad 111B are two of the plurality of electrode pads 111. Specifically, the radiation device includes the transistor substrate 11, the first transistor 110A and the second transistor 110B disposed on the transistor substrate 11, the first electrode pad 111A and the second electrode pad 111B disposed on the transistor substrate 11, and a first conductive line 113A and a second conductive line 113B disposed on the transistor substrate 11. The first electrode pad 111A is disposed adjacent to the first transistor 110A and the second electrode pad 111B is disposed adjacent to the second transistor 110B. The first transistor 110A is electrically connected to the first electrode pad 111A through the first conductive line 113A and the second transistor 110B is electrically connected to the second electrode pad 111B through the second conductive line 113B. The first transistor 110A includes a source 114A, a drain 115A, a semiconductor layer 118A, and a gate 116A. The second transistor 110B includes a source 114B, a drain 115B, a semiconductor layer 118B, and a gate 116B. The first electrode pad 111A is electrically connected to the drain 115A of the first transistor 110A through the first conductive line 113A and the second electrode pad 111B is electrically connected to the drain 115B of the second transistor 110B through the second conductive line 113B. Specifically, the drain 115A and the first conductive line 113A may be substantially formed in the same process and are connected to each other. The portion overlapping with the gate 116A in the normal direction of the transistor substrate 11 may be regarded as the drain 115A, while the remaining portion may be regarded as the first conductive line 113A. In other words, the drain 115A extends from the first transistor 110A and is connected to the first electrode pad 111A in the form of the first conductive line 113A. Similarly, the drain 115B and the second conductive line 113B may be substantially formed in the same process and connected to each other. The portion overlapping with the gate 116B in the normal direction of the transistor substrate 11 may be regarded as the drain 115B, while the remaining portion may be regarded as the second conductive line 113B. In other words, the drain 115B extends from the second transistor 110B and is connected to the second electrode pad 111B in the form of the second conductive line 113B. It should be noted that the source defined above may also be a drain in other embodiments, and the drain defined above may also be a source in other embodiments. That is, in other embodiments of the present disclosure, the source may be the element symbols 115A and 115B, the drain may be the element symbols 114A and 114B, and the disclosure is not particularly limited. It should be noted that only some components are depicted in the embodiments of the present disclosure, and other components are omitted. For example, the gate 116A is actually connected to a scan line, but only the gate 116A is shown in the present disclosure for the sake of illustration.

As shown in Figs. 3A and 3B, the distance between the first transistor 110A and the first electrode pad 111A is shorter than the distance between the second transistor 110B and the second electrode pad 111B. In the present disclosure, the so-called "distance" may refer to the shortest distance between the outline of the projection of the semiconductor layer 118A on the transistor substrate 11 and the outline of the projection of the first electrode pad 111A on the transistor substrate 11, or may refer to the shortest distance between the outline of the projection of the semiconductor layer 118B on the transistor substrate 11 and the outline of the projection of the second electrode pad 111B onto the transistor substrate 11. In Embodiment 1, the outline of the first conductive line 113A is different from the outline of the second conductive line 113B. In the present disclosure, the "different outline" may mean that the shape or size of the first conductive line 113A is different from the shape or size of the second conductive line 113B, such that the projection of the first conductive line 113A on the transistor substrate 11 and the projection of the second conductive line 113B on the transistor substrate 11 cannot completely overlap. In an embodiment, the first conductive line 113A and a portion of the counter electrode 121 form a first coupling capacitor, and the second conductive line 113B and a portion of the counter electrode 121 form a second coupling capacitor. In an embodiment, the length of the first conductive line 113A is shorter than the length of the second conductive line 113B. To make the first coupling capacitor and the second coupling capacitor close to each other, the width of the first conductive line 113A may be greater than the width of the second conductive line 113B. Thereby, the total area of the first conductive line 113A is made to be close to the total area of the second conductive line 113B. For example, the first conductive line 113A may be compensated for so that the ratio of the first coupling capacitor to the second coupling capacitor is between 0.8 and 1.2, or the ratio of the total area of the first conductive line 113A to the total area of the second conductive line 113B is between 0.8 and 1.2. In this embodiment, the first conductive line 113A may have a first portion 113A1 extending along a first direction D1, the second conductive line 113B may having a first portion 113B1 extending along a second direction D2, and the width of the first portion 113A1 of the first conductive line 113A is greater than the width of the first portion 113B1 of the second conductive line 113B. The first direction D1 and the second direction D2 may be the same or different, and the disclosure is not limited thereto. In the present disclosure, the so-called "width" may refer to the maximum width of the conductive line in a direction that is perpendicular to the extension direction. In this embodiment, the first conductive line 113A may further have a second portion 113A2, the first portion 113A1 of the first conductive line 113A connects the second portion 113A2, the second portion 113A2 of the first conductive line 113A extends along a third direction D3, and the first direction D1 is different from the third direction D3. Since the size of the coupling capacitor is proportional to the area, similar coupling capacitors can be obtained with similar total area to compensate for the difference in RC (resistor-capacitor) loading.

In the present disclosure, "total areas are close" and "coupling capacitors are close" mean that the ratio of the total area (and capacitor) of the compensated conductive line to the total area (and capacitor) of the non-compensated conductive line ranges from 0.8 to 1.2. The following is further described with reference to Figs. 4A and 4B.

As shown in Figs. 4A and 4B, the second conductive line 113B connected to the drain of the second transistor 110B has an uncompensated width. Therefore, in the equivalent circuit diagram, the second transistor 110B is connected in parallel two capacitors Cst and CstB. The capacitor Cst is the equivalent capacitor of the second electrode pad 111B, and the capacitor CstB is the equivalent capacitance of the second conductive line 113B. In contrast to this, the first conductive line 113A connected to the drain of the first transistor 110A is widened after being compensated for. The first electrode pad 111A connected to the first transistor 110A and the second electrode pad 111B connected to the second transistor 110B have the same material and the same size. Therefore, the equivalent capacitor of the first electrode pad 111A is also Cst. It is assumed that there is a capacitor CstAl corresponding to the case where the first conductive line 113A maintains the same width as the second conductive line 113B, and an increased capacitor CstA2 which is generated after the width of the first conductive line 113A is increased. Then the total equivalent capacitor of the compensated first conductive line 113A will be CstA1 + CstA2. In the present disclosure, the range satisfying the condition that the coupling capacitors are close to each other means that the ratio of the coupling capacitor of the conductive line after compensation to the coupling capacitor of the conductive line before compensation ranges from 0.8 to 1.2. That is, 0.8 CstB ≦ CstA1 + CstA2 ≦ 1.2CstB. After the compensation, the coupling capacitors in line with this range can achieve the effectiveness of this disclosure.

In Embodiment 1 described above, two sets (the first transistor 110A and the first electrode pad 111A, the second transistor 110B and the second electrode pad 111B) are used as an example. In fact, the conductive line 113 of all sets (the transistor 110 and the electrode pad 111) on the control panel 1 can be compensated for by a value close to the coupling capacitor of the conductive line 113B, so that the coupling capacitors of the conductive lines 113 on the control panel 1 are consistent. The operation of the radiation device can be more uniformly stabilized.

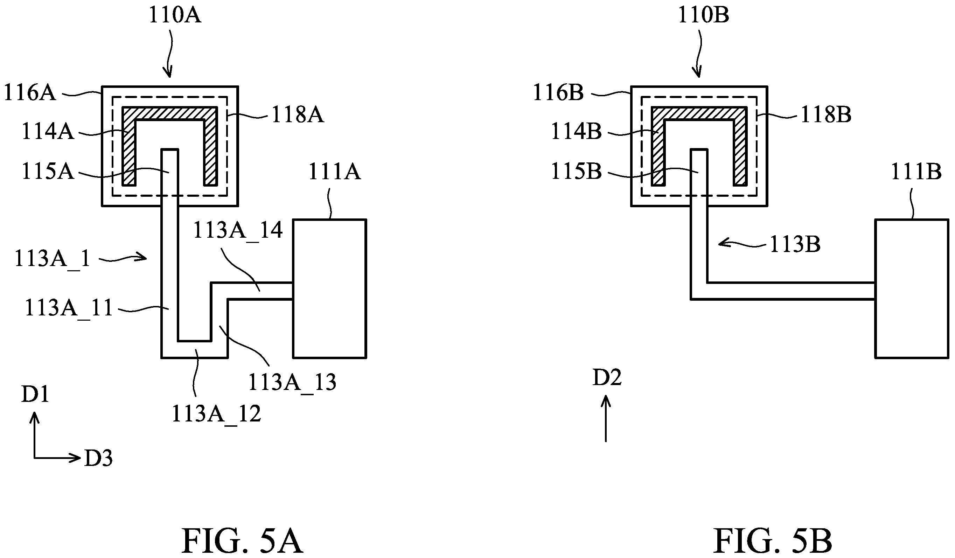

Figs. 5A and 5B show a schematic top view of two sets of transistors and electrode pads in Embodiment 2 of the present disclosure. In Embodiment 2, the size and the positional relationship of the first transistor 110A, the second transistor 110B, the first electrode pad 111A, the second electrode pad 111B and the second conductive line 113B are the same as those in Figs. 3A and 3B. The difference between Embodiment 2 and Embodiment 1 is that the first conductive line 113A_1 adopts a different design from the first conductive line 113A.

As shown in Figs. 5A and 5B, the distance between the first transistor 110A and the first electrode pad 111A is short, and the distance between the second transistor 110B and the second electrode pad 111B is long. In Embodiment 2, the width of the first conductive line 113A_1 is maintained the same as that of the second conductive line 113B. In order to make the first conductive line 113A_1 and the second conductive line 113B have similar coupling capacitors, the length of the first conductive line 113A_1 may be compensated for to be close to the length of the second conductive line 113B, thereby bringing the total area of the first conductive line 113A_1 close to the total area of the second conductive line 113B. For example, the ratio of the length of the first conductive line 113A_1 to the length of the second conductive line 113B may be between 0.8 and 1.2, and the ratio of the total area of the first conductive line 113A_1 and the total area of the second conductive line 113B may be between 0.8 and 1.2. As shown in Figs. 5A and 5B, the length of the first conductive line 113A1 is compensated for by adding a U-shape. Specifically, the first conductive line 113A_1 may have a first portion 113A_11, a second portion 113A_12, a third portion 113A_13, and a fourth portion 113A_14. The first portion 113A_11 of the first conductive line 113A_1 connects the second portion 113A_12, the second portion 113A_12 of the first conductive line 113A_1 connects the third portion 113A_13, and the third portion 113A_13 of the first conductive line 113A_1 connects the fourth portion 113A_14. The first portion 113A_11 of the first conductive line 113A_1 may extend along the first direction D1 and the second portion 113A_12 of the first conductive line 113A_1 may extend along the third direction D3. The first direction D1 is different from the third direction D3. In an embodiment, the third portion 113A_13 of the first conductive line 113A_1 may extend along the first direction D1, the fourth portion 113A_14 of the first conductive line 113A_1 may extend along the third direction D3. However, in other embodiments, the extending direction of the third portion 113A_13 may be different from that of the first portion 113A_11, and the extending direction of the fourth portion 113A_14 may be different from the second portion 113A_12, and the disclosure is not limited thereto. Since the size of the coupling capacitor is proportional to the area, similar coupling capacitors can be obtained with similar total area to compensate for inconsistencies in the RC loading.

Similarly, in Embodiment 2, the so-called "the lengths are close" means that the width of the conductive line is similar, and the ratio of the length of the compensated conductive line to the length of the non-compensated conductive line is between 0.8 and 1.2.

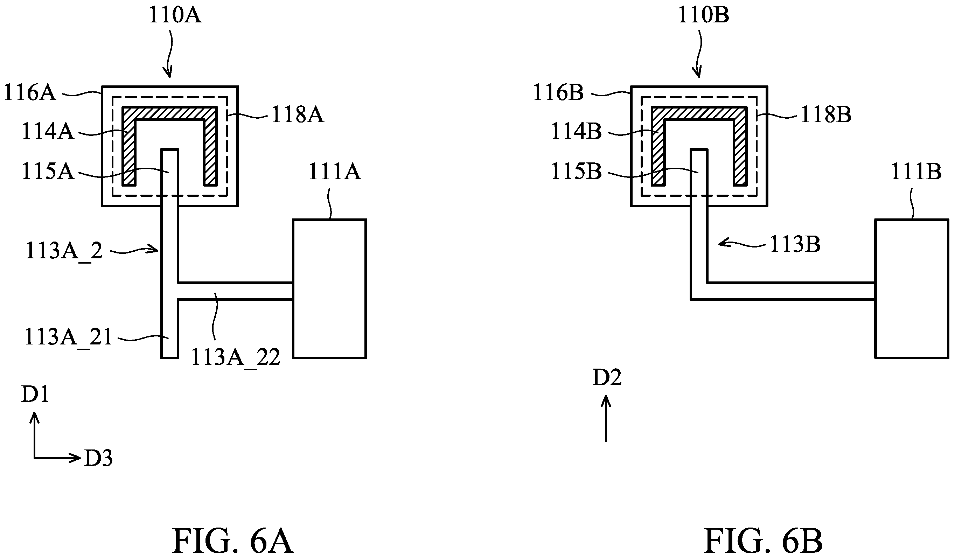

Figs. 6A and 6B show a schematic top view of two sets of transistors and electrode pads in Embodiment 3 of the present disclosure. In embodiment 3, the sizes and positional relationships of the first transistor 110A, the second transistor 110B, the first electrode pad 111A, the second electrode pad 111B, and the second conductive line 113B are the same as those in Figs. 3 and 5. The difference between Embodiment 3 and Embodiment 1 or 2 is that the first conductive line 113A 2 adopts a different design from the first conductive lines 113A and 113A_1.

As shown in Figs. 6A and 6B, the distance between the first transistor 110A and the first electrode pad 111A is short, and the distance between the second transistor 110B and the second electrode pad 111B is long. In Embodiment 3, the width of the first conductive line 113A_2 may be similar to that of the second conductive line 113B. In order to make the first conductive line 113A_2 and the second conductive line 113B have similar coupling capacitors, the length of the first conductive line 113A_2 may be compensated for to be close to the length of the second conductive line 113B, thereby bringing the total area of the first conductive line 113A_2 close to the total area of the second conductive line 113B. As shown in Figs. 6A and 6B, the length of the first conductive line 113A_2 is compensated for by designing a T shape. Specifically, the first conductive line 113A_2 may have a first portion 113A_21 and a second portion 113A_22. The first portion 113A_21 of the first conductive line 113A_2 may be connected to the second portion 113A_22. The first portion 113A_21 of the first conductive line 113A 2 may extend along the first direction D1, and the second portion 113A_22 of the first conductive line 113A 2 may extend along the third direction D3. The first direction D1 is different from the third direction D3. The first portion 113A_21 of the first conductive line 113A_2 is adjacent to the first transistor 110A, and the second portion 113A_22 of the first conductive line 113A_2 is adjacent to the first electrode pad 111A. Specifically, the first portion 113A_21 and the second portion 113A_22 of the first conductive line 113A_2 may be formed in the same process and connected to each other, but they are not limited thereto. In Fig. 6A, the manner in which the first portion 113A_21 and the second portion 113A_22 of the first conductive line 113A_2 are connected is only an example. In other embodiments, the first portion 113A_21 and the second portion 113A_22 of the first conductive line 113A 2 may be connected in different manners, but the disclosure is not limited thereto. Since the size of the coupling capacitor is proportional to the area, similar coupling capacitors can be obtained with similar total area to compensate for inconsistencies in the RC loading.

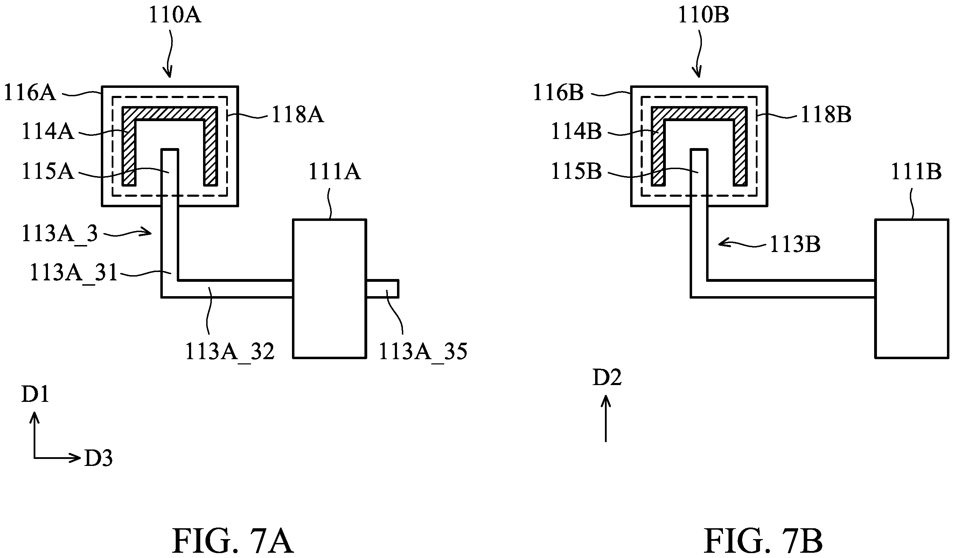

Figs. 7A and 7B show a schematic top view of two sets of transistors and electrode pads in Embodiment 4 of the present disclosure. In embodiment 4, the sizes and positional relationships of the first transistor 110A, the second transistor 110B, the first electrode pad 111A, the second electrode pad 111B, and the second conductive line 113B are the same as those in Figs. 3, 5, and 6. The difference between Embodiment 4 and Embodiment 1, 2, or 3 is that the first conductive line 113A_3 adopts a different design from the first conductive lines 113A, 113A_1, and 113A_2.

As shown in Figs. 7A and 7B, the distance between the first transistor 110A and the first electrode pad 111A is short, and the distance between the second transistor 110B and the second electrode pad 111B is long. In Embodiment 4, the width of the first conductive line 113A_3 may be similar to that of the second conductive line 113B. In order to make the first conductive line 113A_3 and the second conductive line 113B have similar coupling capacitors, the length of the first conductive line 113A_3 may be compensated for to be close to the length of the second conductive line 113B, thereby bringing the total area of the first conductive line 113A_3 close to the total area of the second conductive line 113B. As shown in Figs. 7A and 7B, the length of the first conductive line 113A_3 is compensated for by designing one more conductive line on the other side of the first electrode pad 111A. Specifically, the first conductive line 113A_3 may have a first portion 113A_31, a second portion 113A_32, and a fifth portion 113A_35. The first portion 113A_31 of the first conductive line 113A_3 connects the second portion 113A_32, and the second portion 113A_32 of the first conductive line 113A_3 connects the fifth portion 113A_35. The first portion 113A_31 extends along the first direction D1, the second portion 113A_32 extends along the third direction D3, and the first direction D1 is different from the third direction D3. The first portion 113A_31 is adjacent to the first transistor 110A, and the second portion 113A 32 is adjacent to the first electrode pad 111A. The first electrode pad 111A is disposed between the first portion 113A_31 and the fifth portion 113A_35 in the normal direction of the transistor substrate 11. Specifically, the first portion 113A_31, the second portion 113A_32, and the fifth portion 113A_35 may be formed in the same process and connected to each other, but they are not limited thereto. The fifth portion 113A_35 can be regarded as the portion of the first conductive line 113A_3 extending further outwardly from the first electrode pad 111A after passing under the first electrode pad 111A. Since the size of the coupling capacitor is proportional to the area, similar coupling capacitors can be obtained with similar total area to compensate for inconsistencies in the RC loading.

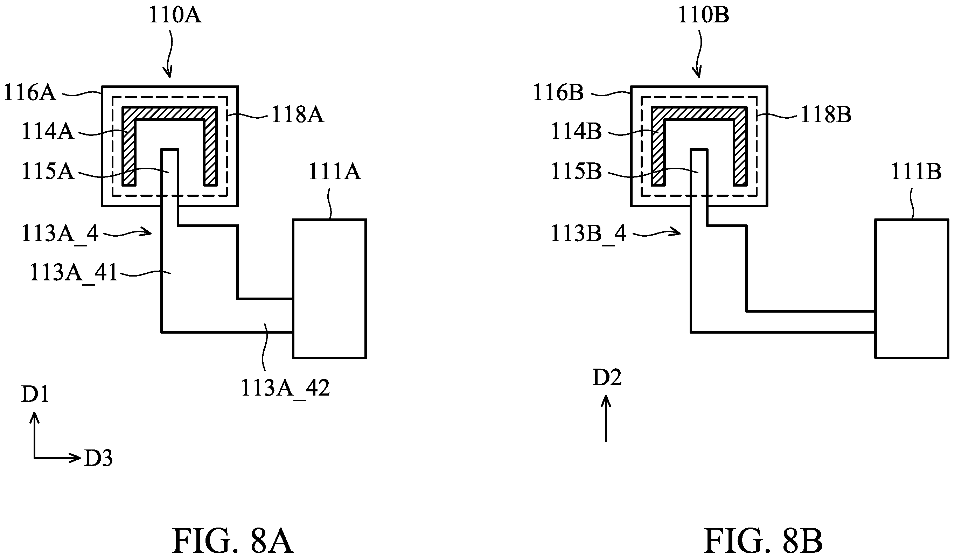

Figs. 8A and 8B show a schematic top view of two sets of transistors and electrode pads in Embodiment 5 of the present disclosure. In embodiment 5, the sizes and positional relationships of the first transistor 110A, the second transistor 110B, the first electrode pad 111A, and the second electrode pad 111B are the same as those in Figs. 3, 5, 6, and 7. The difference between Embodiment 5 and Embodiment 1, 2, 3, or 4 is that the first conductive line 113A 4 adopts a different design from the first conductive lines 113A, 113A_1, 113A_2, and 113A_3, and the second conductive line 113B_4 adopts a different design from the second conductive line 113B.

The design concept in Embodiment 5 and Embodiment 1 are similar, and the total area of each conductive line is made close to each other by adjusting the width of the conductive line. The difference is that the variation in the width of the first conductive line 113A in Embodiment 1 is small, and the first conductive line 113A_4 in Embodiment 5 may have different widths. The variation of the width of the second conductive line 113B in Embodiment 1 is small, but the second conductive line 113B_4 in Embodiment 5 may have different widths. However, the present disclosure is not limited thereto. For example, the first conductive line 113A_4 may have a first portion 113A_41 and a second portion 113A_42. The first portion 113A_41 of the first conductive line 113A_4 may connect to the second portion 113A_42. The first portion 113A_41 of the first conductive line 113A_4 may extend along the first direction D1, the second portion 113A_42 of the first conductive line 113A_4 extends along the third direction D3, and the first direction D1 is different from the third direction D3. The first portion 113A_41 of the first conductive line 113A_4 is adjacent to the first transistor 110A and the second portion 113A_42 of the first conductive line 113A_4 is adjacent to the first electrode pad 111A. In this embodiment, the width of the first portion 113A_41 of the first conductive line 113A_4 is different from the width of the second portion 113A_42. In the present disclosure, the so-called "width" may mean the maximum width of the first portion 113A_41 or the second portion 113A_42 of the first conductive line 113A_4. Thereby, the total area of the first conductive line 113A_4 can be close to the total area of the second conductive line 113B_4. For example, the ratio of the total area of the first conductive line 113A_4 to the total area of the second conductive line 113B_4 is between 0.8 and 1.2. Therefore, the first conductive line 113A_4 and the second conductive line 113B_4 can generate a similar coupling capacitor, thereby compensating for the inconsistency of the RC loading. It should be noted that, the conductive line outline in this embodiment is merely an example, and other outlines may be designed in other embodiments, but the disclosure is not limited thereto.

According to various embodiments described above, the present disclosure provides a radiation device, which may be an antenna device that can receive or emit radiation in a high-frequency band (the high-frequency band can be, for example, between 1 GHz and 80 GHz). By designing the conductive lines in the radiating device in a variety of ways, the coupling capacitors generated by the conductive lines can be approached, so that the operation of the radiating device can be more uniformly stabilized.

The above-disclosed features can be combined, modified, substituted, or diverted to one or more of the disclosed embodiments in any suitable manner without being limited to a specific embodiment.

While the invention has been described by way of example and in terms of the preferred embodiments, it is to be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A control panel (1), comprising
a transistor substrate (11);
a first transistor (110A) and a second transistor (110B) disposed on the transistor substrate;
a first electrode pad (111A) and a second electrode pad (111B) disposed on the transistor substrate, wherein the first electrode pad is disposed adjacent to the first transistor, and the second electrode pad is disposed adjacent to the second transistor; and
a first conductive line (113A) and a second conductive line (111B) disposed on the transistor substrate, wherein the first transistor is electrically connected to the first electrode pad through the first conductive line, and the second transistor is electrically connected to the second electrode pad through the second conductive line,
wherein a distance between the first transistor (110A) and the first electrode pad (111A) is shorter than a distance between the second transistor (110B) and the second electrode pad (111B), and a ratio of a total area of the first conductive line (113A) and a total area of the second conductive line (113B) is between 0.8 and 1.2.

2. The control panel (1) as claimed in claim 1, wherein a ratio of a length of the first conductive line (113A) to a length of the second conductive line (113B) is between 0.8 and 1.2.

3. The control panel (1) as claimed in claim 1 or 2, wherein the first conductive line (113A) has a first portion (113A1) extending along a first direction (D1), the second conductive line (113B) has a first portion (113B1) extending along a second direction (D2), and a width of the first portion of the first conductive line is greater than a width of the first portion of the second conductive line.

4. The control panel as claimed in one of claims 1-3, wherein the first conductive line (113A) has a first portion (113A1) and a second portion (113A2), the first portion of the first conductive line is connected to the second portion, the first portion of the first conductive line extends along a first direction (D1), the second portion of the first conductive line extends along a third direction (D3), and the first direction is different from the third direction.

5. The control panel as claimed in claim 4, wherein the first conductive line (113A_3) further has a third portion (113A_13) and a fourth portion (113A_14), the second portion (113_A12) of the first conductive line is connected to the third portion, the third portion of the first conductive line is connected to the fourth portion, the third portion of the first conductive line extends along the first direction (D1), and the fourth portion of the first conductive line extends along the third direction (D3).

6. The control panel as claimed in claim 4 or 5, wherein the first conductive line (113A_3) further has a fifth portion (113A_35), the second portion (113A_32) of the first conductive line is connected to the fifth portion, and the first electrode pad (111A) is disposed between the first portion and the fifth portion.

7. The control panel as claimed in one of claims 4-6, wherein a width of the first portion (113A_31) of the first conductive line is different from a width of the second portion (113_32).

8. The control panel as claimed in one of claims 1-7, further comprising a counter substrate (12) disposed opposite to the transistor substrate (11);
a dielectric layer (13) disposed between the counter substrate and the transistor substrate; and
a counter electrode (121) disposed on a surface of the counter substrate, the surface of the counter substrate being adjacent to the dielectric layer,
wherein a portion of the counter electrode (121) and the first electrode pad (111A) form a modulation unit (P).

9. The control panel as claimed in claim 8, wherein the first conductive line (113A) and a portion of the counter electrode (121) form a first coupling capacitor, the second conductive line (113B) and a portion of the counter electrode (121) form a second coupling capacitor, and a ratio of the first coupling capacitor to the second coupling capacitor is between 0.8 and 1.2.

10. The control panel (1) as claimed in claim 8 or 9, wherein the control panel is used in an antenna device, and
the modulation unit (P) in the control panel (1) controls the dielectric layer (13) to transmit or receive a high-frequency radiation signal.

11. A radiation device comprising a control panel (1) according to any of the preceding claims.
